**Europäisches Patentamt**

**European Patent Office**

**Office européen des brevets**

(11) Veröffentlichungsnummer: **0 007 447**
**A1**

(12) # EUROPÄISCHE PATENTANMELDUNG

(21) Anmeldenummer: **79102126.4**

(22) Anmeldetag: **26.06.79**

(51) Int. Cl.³: **C 25 D 1/08**
**G 03 F 7/20, H 01 J 37/04**

(30) Priorität: 24.07.78 DE 2832406

(43) Veröffentlichungstag der Anmeldung:
06.02.80 Patentblatt 80/3

(84) Benannte Vertragsstaaten:
FR GB NL

(71) Anmelder: SIEMENS AKTIENGESELLSCHAFT Berlin
und München
Postfach 261
D-8000 München 22(DE)

(72) Erfinder: Trausch, Günter-Elmar, Dipl.-Ing.
Feldafinger Strasse 39b
D-8000 München 71(DE)

(54) Verfahren zur Herstellung von Präzisionsflachteilen, insbesondere mit Mikroöffnungen und Anwendung des Verfahrens.

(57) Um beliebig kleine Öffnungen in einem Flachteil zu erzeugen, wird auf einem planen Glasträger (1) eine Metallschablone (2) erzeugt, auf der das gewünschte Flachteilmaterial, z.B. Gold (4), in gewünschter Stärke galvanisch abgeschieden wird. An den Grenzen der Schablone wächst die Plattierschicht um einen definierten Betrag auch in seitlicher Richtung an. Auf diese Weise sind beliebig kleine Öffnungen sehr exakt in einem Flachteil herzustellen.

FIG 1

FIG 2

FIG 3

EP 0 007 447 A1

Croydon Printing Company Ltd.

BEZEICHNUNG GEÄNDERT
siehe Titelseite

SIEMENS AKTIENGESELLSCHAFT
Berlin und München

Unser Zeichen
VPA
78 P 7 0 6 7

Verfahren zur Herstellung von Präzisionsflachteilen, insbesondere mit Mikroöffnungen.

Die Erfindung betrifft ein Verfahren zur Herstellung von Präzisionsflachteilen, wie Blenden, Schablonen, Masken, insbesondere mit Mikroöffnungen, auf einem planen Glasträger, der einseitig eine dünne Metallschicht trägt, auf der aus einem Fotoresist eine Struktur erzeugt wird.

Bei der Herstellung von Präzisionsflachteilen, wie Blenden, Schablonen, Masken besteht Bedarf, Fensteröffnungen und Konturendetails mit Abmessungen bis herab in den Mikrometerbereich bei entsprechend geringer Maßabweichung und Rauhigkeit der Konturen zu erzeugen. Gleichzeitig darf eine bestimmte Materialstärke aus Festigkeitsgründen nicht unterschritten werden. Als weiteres Problem stellt sich die Stabilität bei der Handhabung und bei Reinigungsprozessen solcher empfindlicher Teile dar.

Zum Herstellen von Flachteilen, für die wegen der Genauigkeitsforderungen die chemische Ätztechnik nicht mehr

Wed 1 Flr / 19.7.1978

0007447

ausreicht, verwendet man zumeist das Galvanoplastikverfahren. Es wird hier auf einem Hilfsträger fotolithographisch eine Struktur erzeugt, durch die die Begrenzungen des Flachteiles, also die Konturen, festgelegt werden. Um diese Strukturen scheidet man galvanisch Metall ab und löst nach Entfernung des Fotoresists das so erhaltene Teil vom Träger ab. Stärke und Konturenqualität der Galvanoplastik sind begrenzt durch Höhe und Flankenqualität des Fotoresists. Die mögliche Feinheit und Qualität der Reststrukturen nimmt mit der Reststärke ab.

Um trotzdem ausreichende Stabilität zu haben, erzeugt man häufig zunächst eine "Feinmaske" und verstärkt sie in allen unkritischen Bereichen zu einer tragfähigen "Grobmaske". Ein derartiges Verfahren ist in der DE-AS 24 25 464 beschrieben und dargestellt.

Feinmasken lassen sich in jüngster Zeit auch durch Ionen- und Plasmaätzen herstellen. Aber auch damit ist die benötigte Feinheit oft nicht zu erreichen. Die fertigen Teile werden entweder vom Träger abgezogen oder dieser wird chemisch aufgelöst, wobei die Einzelteile "aufgefischt" und einzeln oder im Nutzen (Mehrfachanordnung) weiterbehandelt werden.

Der Erfindung liegt die Aufgabe zugrunde, mit möglichst einfachen Mitteln das eingangs genannte Verfahren zu realisieren, um beliebig kleine Öffnungen bei ausreichend starker Materialstärke zu erhalten. Es ist nämlich durchaus möglich, in einem Material mit z. B. 0,3 $\mu$m Stärke ätz- oder abhebetechnisch Öffnungen im Mikronbereich herzustellen. Diese Materialstärken reichen jedoch für freitragende Teile nicht aus.

Die Lösung der Erfindung besteht darin, daß die nicht abgedeckte Fläche der Metallschicht mit einem definierten Abmaß gegenüber den Abmessungen des zu erzeugenden Teiles abgeätzt wird, wobei Metallstege die Verbindung zum Glasträgerrand und bei Mehrfachanordnung auch zwischen den Einzelteilen herstellen, der Fotoresist entfernt und auf der so erzeugten Metallschablone ein Flachteilmaterial galvanisch (Plattierung) abgeschieden wird, wobei man an den Grenzen der Schablone die Plattierschicht um das Abmaß in seitlicher Richtung wachsen läßt und so eine Feinmaske erhält, anschließend die wegen ihrer Feinheit kritischen Bereiche mit Fotoresist abdeckt, die nicht abgedeckten Flächen galvanisch zu einem mechanisch stabilen Flachteil (Grobmaske) verstärkt, den Glasträger sowie das Schablonenmetall abätzt und den Fotoresist entfernt.

Unter Abmaß ist zu verstehen, daß die Öffnungen gegenüber den Abmessungen des zu erzeugenden Teiles größer sind, so daß nur Strukturgrößen vorkommen, die fototechnisch sicher beherrschbar sind. Das gewünschte Endmaß wird bei der Erfindung durch gezieltes Seitenwachstum erreicht. Das Wachsen der Plattierschicht an den Grenzen der Schablone in seitlicher Richtung, also über das Glas, erfolgt in einem bestimmten konstanten Verhältnis zur Plattierungshöhe, das heißt senkrecht zum Substrat. Wenn dieses Verhältnis empirisch ermittelt ist, liegt für eine geforderte Aufbauhöhe (Flachteilstärke) auch das Aufmaß fest, mit dem anfangs die Plattierungsbasis versehen wird. Man erhält also beim Plattierungsvorgang durch kontinuierliche Verschiebung der Flachteilkonturen bei Beendigung des Plattierens die gewünschten Abmessungen. Es ist damit möglich, beliebig kleine Öffnungen in einem Flachteil zu erzeugen, die ätztechnisch oder anders nicht erreicht werden können.

Ferner ist eine Mehrfachanordnung von Flachteilen auf einem Träger möglich, wobei die einzelnen Flachteile durch Stege miteinander verbunden sind.

Die bekannte Fotoresistunterwanderung in vielen Galvanikbädern (z. B. für Hartgold), die zu rauhen Konturen und/oder Maßabweichungen führt, ist bei der Erfindung ausgeschaltet. Die Flachteilkanten sind darüber hinaus bei dem Verfahren nach der Erfindung so geneigt, daß die Kontur durch einen äußerst dünnen Rand exakt definiert ist. Diese Form eignet sich besonders gut für Blenden und Schablonen. Unerwünschte kleinere Löcher in der Plattierungsbasis werden durch das Seitenwachstum des Plattiermaterials geschlossen.

In der Regel ist es erforderlich, die nun vorliegende Feinmaske zu verstärken. Das kann auf herkömmliche Weise mit Hilfe einer dicken Fotoresistschicht und durch Plattieren erfolgen. Das fertige Flachteil könnte danach unter Umständen vom Glas abgezogen werden, wobei sich jedoch bei guter Haftung die Ränder der Öffnungen verbiegen würden und bei Nutzenanordnung (Mehrfachanordnung) die Einzelteile jedes für sich weiter behandelt werden müßten.

Nach einer Weiterbildung der Erfindung wird ein umlaufender Glasrand, der keine Flachteile trägt, abgedeckt und nur die innerhalb liegenden Glas- und Metallschablonenbereiche aufgelöst.

Dadurch wird die Stabilität bei der Handhabung wesentlich gesteigert. Auf diese Weise erhält man Einzelteile, die, verbunden durch Stege, oder ein größeres Teil mit Haltestegen, in einem stabilen Glasrahmen gespannt sind. Nach diesem Verfahren lassen sich jetzt gut die restlichen Prozeßschritte einschließlich Revision ausführen. Außerdem läßt sich damit die Verpackung und der Transport wesentlich vereinfachen, da nicht jedes Einzelflachteil gesondert verpackt werden muß.

Bei einer aus Grob- und Feinmaske zusammengesetztem Galvanoplastik besteht ein weiterer Vorteil des Verfahrens darin, daß Negativ-Resist zur Erzeugung der Grobmaske verwendet und dieser durch den Glasträger belichtet wird, wobei die Feinmaske als Belichtungsmaske dient und zusätzlich die Belichtung zum Freihalten der kritischen Bereiche der Feinmaske auf die übliche Weise durch eine Belichtungsmaske von der metallisierten Glasseite her erfolgt. Die bekannten Verfahren, eine Grob- und Feinmaske einander optisch zuzuordnen, erfordern einen beträchtlichen Aufwand. Das wird mit der vorgeschlagenen Lösung behoben und außerdem Lagefehler ausgeschlossen. Zweckmäßig ist z. B. die Anwendung des Verfahrens nach der Erfindung zur Herstellung von Dünnschicht-Aperturblenden für Korpuskularstrahlgeräte, insbesondere Elektronenmikroskope und Vidikone.

Die Erfindung wird anhand der Figuren 3 bis 6 erläutert. Es zeigen:

Figur 1 einen Glasträger mit einer einseitig dünnen Metallschicht und einer Fotoresistauflage,

Figur 2 den Glasträger, nachdem die Metallschicht geätzt und der Fotoresist entfernt ist,

Figur 3 das Flachteil nach der Figur 2 mit einer Plattierschicht (Feinmaske),

Figur 4 die Verstärkung der Feinmaske zur Grobmaske,

Figur 5 die Gesamtmaske nachdem der Träger abgeätzt und der Fotoresist entfernt ist und

Figur 6 die Gesamtansicht einiger Blenden (Dünnschicht-
Aperturblenden) mit Glasrahmen.

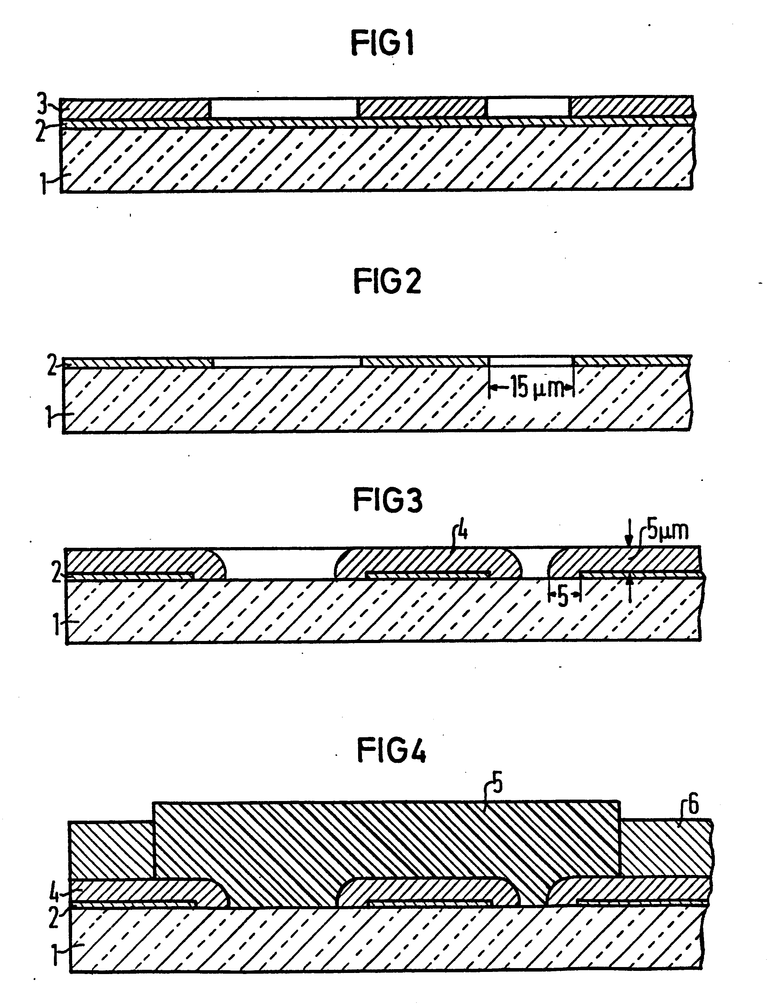

Zur Herstellung von Präzisionsflachteilen wird gemäß Abbildung 1 auf einem planen Glasträger 1 eine Haftschicht
aus Titan und darauf eine Ankontaktierschicht aus Kupfer
aufgedampft. Anschließend wird auf dieser Metallschicht 2
aus dünnem, hochauflösendem Fotolack eine Struktur 3 auf
der Metallbasis erzeugt, die sich durch höchstmögliche
Konturenqualität und ein definiertes Abmaß gegenüber den
Abmessungen des zu erzeugenden Teiles auszeichnet. Unter
Abmaß ist zu verstehen, daß die Öffnungen in der Schablone
mit einem größeren Durchmesser erzeugt werden, als es bei
den Abmessungen des zu erzeugenden Teiles gefordert wird.
Auf diese Weise kommen nur Strukturgrößen vor, die fototechnisch sicher beherrschbar sind. Die nicht abgedeckte
Fläche der Metallschicht 2 wird mit einer Ätze aufgelöst,
und der Fotoresist 3 entfernt. Nach der Darstellung in
der Figur 2 liegt nun quasi eine fest mit dem Glas verbundene Metallschablone vor, wobei jedoch alle Konturen
um einen konstanten Betrag verschoben sind, das heißt,
alle Fensteröffnungen sind in der angedeuteten Weise zu
groß. Das im rechten Teil dieser Figur gezeichnete Fenster
hat einen Durchmesser von 15 /um, während der Durchmesser
des Fensters in dem zu erzeugenden Teil, wie aus der
Figur 3 hervorgeht, z. B. nur noch 5 /um beträgt.

In der Figur 3 ist eine Feinmaske dargestellt, die dadurch
entsteht, daß auf der Metallschablone das gewünschte Flachteilmaterial 4, zum Beispiel Gold, in gewünschter Stärke
galvanisch abgeschieden wird. Wie aus dieser Figur hervorgeht, wächst an den Grenzen der Schablone die Plattierschicht auch in seitlicher Richtung, also über das Glas,
und zwar in einem bestimmten Verhältnis zur Plattierungshöhe senkrecht zum Substrat. Als Plattierungshöhe ist
beispielsweise 5 /um angenommen und bei diesem Ausführungsbeispiel auch ein Seitenwachstum um 5 /um pro Kante erzielt worden. Auf diese Weise ist es möglich, beliebig kleine Öffnungen in einem Flachteil zu erzeugen, da das Seitenwachstum in einem bestimmten Verhältnis zur Plattierungshöhe erfolgt und damit sehr exakt definierte Öffnungen erzielt werden können.

Wenn es erforderlich ist, diese Feinmaske zu verstärken, dann kann, wie das in der Figur 4 angedeutet ist, dies in herkömmlicher Weise mit Hilfe einer dicken Negativfotoresistschicht 5 und durch Plattieren, z. B. mit Kupfer, 6 erfolgen. Zur genauen Zuordnung Grobmaske 6 zu Feinmaske 4 erfolgt die Belichtung durch das Glas 1 und die Feinmaske sowie mit einer 2. Belichtung nur an den Teilen die als Feinmaske erhalten bleiben sollen von der metallisierten Seite her mit einer entsprechenden Maske.

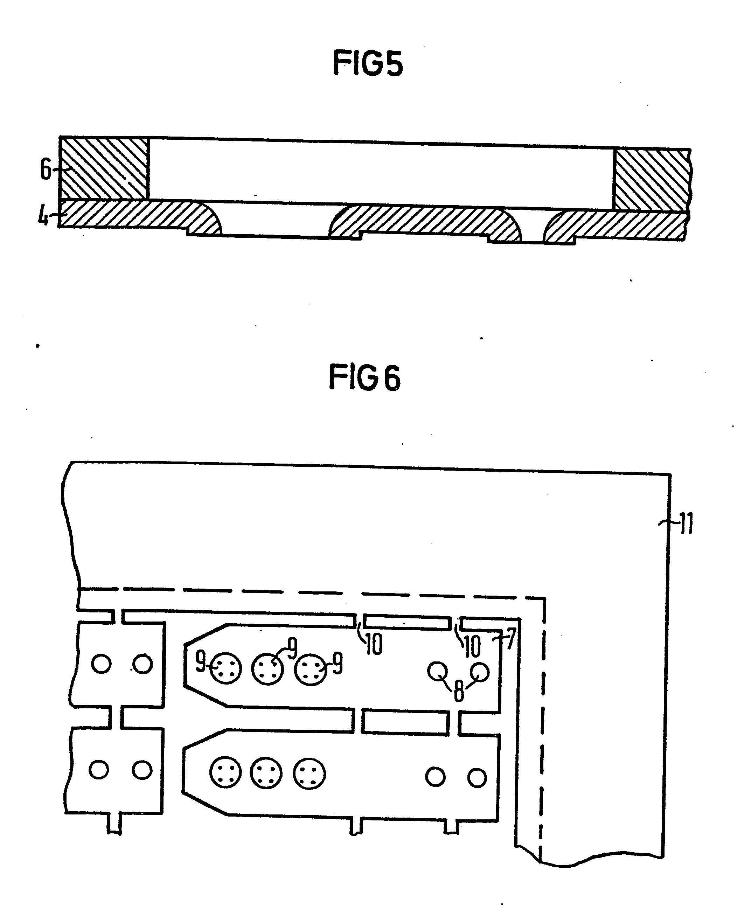

Die Figur 5 zeigt das Flachteil, nachdem die Metallschicht 2 und der Träger 1 abgeätzt und der Fotoresist entfernt wurde. Das Flachteil ist von einem in Figur 6 dargestellten umlaufenden Glasrand 11 über Verbindungsstege 10 gehalten.

Bei Nutzenanordnung (Mehrfachanordnung) sind dann die Einzelteile verbunden durch Stege oder ein größeres Teil mit Haltestegen in dem Glasrahmen gespannt. Damit lassen sich jetzt gut die restlichen Prozeßschritte, wie Abätzen der dünnen Metallschicht auf der Flachteilunterseite, mit der anfangs das Glas metallisiert wurde, Entschichten des Fotoresists, Reinigen der Teile, Verpacken und Verschicken ausführen.

Die Figur 6 zeigt die Gesamtansicht einiger Blenden mit den Haltestegen 10 und einem Teil des Glasrahmens 11. In der über der Feinmaske liegenden Grobmaske 7, z. B. aus

Kupfer, sind Paßlöcher 8 vorgesehen, mit der die Blende in einer Halterung zu befestigen ist. Mit 9 sind freiliegende Feinmaskenbereiche, z. B. aus Gold, bezeichnet, von denen jeder mit vier Blendenöffnungen versehen ist.

Die Erfindung ist nicht auf das beschriebene und dargestellte Ausführungsbeispiel beschränkt. Statt Mikroöffnungen und Konturendetails ist es z. B. auch möglich, Flachteile mit sehr exakten Abmessungen anwachsen zu lassen.

4 Patentansprüche
6 Figuren

Patentansprüche.

1. Verfahren zur Herstellung von Präzisionsflachteilen, wie Blenden, Schablonen, Masken, insbesondere mit Mikroöffnungen, auf einem planen Glasträger, der einseitig eine dünne Metallschicht trägt, über der fotolithographisch das Flachteilbild erzeugt wird, d a d u r c h g e - k e n n z e i c h n e t , daß die nicht abgedeckte Fläche der Metallschicht (2) mit einem definierten Abmaß gegenüber den Abmessungen des zu erzeugenden Teiles abgeätzt wird, wobei Metallstege die Verbindung zum Glasträgerrand und bei Mehrfachanordnung auch zwischen den Einzelteilen herstellen, der Fotoresist (3) entfernt und auf der so erzeugten Metallschablone ein Flachteilmaterial (4) galvanisch (Plattierung) abgeschieden wird, wobei man an den Grenzen der Schablone die Plattierschicht um das Abmaß in seitlicher Richtung wachsen läßt und so eine Feinmaske erhält, anschließend die wegen ihrer Feinheit kritischen sowie die außerhalb des Teiles liegenden Bereiche mit Fotoresist (5) abdeckt, die nicht abgedeckten Flächen galvanisch (6) zu einem mechanisch stabilen Flachteil (Grobmaske) verstärkt, den Glasträger (1) sowie das Schablonenmetall (2) abätzt und den Fotoresist (5) entfernt.

2. Verfahren nach Anspruch 1, d a d u r c h g e - k e n n z e i c h n e t , daß ein umlaufender Glasrand, der keine Flachteile trägt, abgedeckt wird und nur die innerhalb liegenden Glas- und Metallschablonenbereiche aufgelöst werden.

3. Verfahren nach Anspruch 1 und 2, d a d u r c h g e - k e n n z e i c h n e t , daß Negativ-Resist (5) zur Erzeugung der Grobmaske verwendet und dieser durch den Glasträger (1) belichtet wird, wobei die Feinmaske als Belichtungsmaske dient und zusätzlich die Belichtung zum Freihalten der kritischen Bereiche der Feinmaske auf die übliche Weise durch eine Belichtungsmaske von der metallisierten Glasseite her erfolgt.

4. Anwendung des Verfahrens nach Anspruch 1 zur Herstellung von Dünnschicht-Aperturblenden für Korpuskularstrahlgeräte, insbesondere Elektronenmikroskope und Vidikone.

## FIG 1

## FIG 2

←15 μm→

## FIG 3

5μm

## FIG 4

FIG5

FIG 6

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | FR - A - 2 074 740 (LA RADIO TECHNIQUE COMPELEC) <br> * Figuren 1a-1e * <br><br> -- | 1,2 |
| A | DE - A - 2 436 274 (HEIDENHAIN) | |
| A | FR - A - 2 266 955 (SIEMENS) | |
| A | US - A - 3 900 359 (BAKEWELL) <br><br> ---- | |

**KLASSIFIKATION DER ANMELDUNG (Int.Cl. ³)**

C 25 D 1/08
G 03 F 7/20
H 01 J 37/04

**RECHERCHIERTE SACHGEBIETE (Int. Cl. ³)**

C 25 D 1/08
G 03 F 7/20
C 23 F 1/08
H 01 J 37/04

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen· angeführtes Dokument
&: Mitglied der gleichen Patent- familie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 04-10-1979 | NGUYEN THE NGHIEP |

EPA form 1503.1 06.78